# EUROPÄISCHE PATENTANMELDUNG

(11) **EP 0 539 813 A1**
(43) Veröffentlichungstag der Anmeldung: **05.05.1993**
(21) Anmeldenummer: 92117754.9
(22) Anmeldetag: 16.10.1992
(51) Int. Cl.: H01L 27/02

(54) **Schaltungsanordnung zum Schutz integrierter Schaltkreise**

(30) Priorität: 28.10.1991 DE 4135522
(71) Anmelder: SIEMENS AKTIENGESELLSCHAFT, D-80333 München (DE)
(72) Erfinder: Hartmud, Terletzki, Dipl.-Ing. (TU), W-8012 Ottobrunn (DE); Wolfgang, Nikutta, Dipl.-Phys., W-8000 München 90 (DE)

(57) **Zusammenfassung**

Zum Schutz gegen Zerstörung bei elektrostatischen Entladungen (ESD) müssen Halbleiterchips Schutzschaltungen (PC) besitzen. Üblich sind eine Diode (D) zwischen den Versorgungspotential-Anschlüssen (VSS, VCC) und ESD-Schutzschaltungen. Eine Schutzschaltung zwischen einem Schaltkreisanschluß (P) und einer Versorgungspotential-Leitung (L2) bietet keinen vollständigen Schutz, da die Leitungswiderstände bei ausgedehnten Leitungslängen in Verbindung mit parasitären Kapazitäten hohe Spannungsspitzen verursachen. Die Erfindung schlägt deshalb vor, an jedem Schaltkreisanschluß (P) ein Ableitelement (SD) zwischen die Versorgungspotential-Leitungen (L1, L2) zu schalten.

## Beschreibung

Die Erfindung betrifft eine Schaltungsanordnung zum Schutz integrierter Schaltkreise, insbesondere CMOS-Schaltkreise, bei der zwischen einem Schaltkreis-Anschluß und einer Versorgungspotential-Leitung bzw. zwischen Versorgungspotential-Anschlüssen Ableitelemente geschaltet sind.

Derartige Schaltungsanordnungen sind beispielsweise aus der US-PS 4,829,350 bekannt. Hintergrund für derartige Schaltungen ist die Tatsache, daß heutige MOS-Bauelemente, insbesondere CMOS-Bauelemente, bei der Fertigung und beim Umgang eine hohe Ausfallrate aufgrund elektrostatischer Entladungen (ESD) von Mensch und Maschine aufweisen. Zur Verringerung der Ausfallrate dienen die Schutzschaltungen, die auf dem Bauelement mitintegriert werden. Solche Schaltungen schützen dann die empfindlichen Gateoxide der Eingangstransistoren vor Überspannungen. Ohne diesen Bausteinschutz können Spannungen von weniger als 20 V zur Zerstörung der Bauelemente führen, was bei Bausteinen mit separatem Schutz einige tausend Volt erfordert.

Das Problem der ESD-Verträglichkeit wird verschärft durch eine zunehmende Verringerung der Gateoxiddicke der Transistoren und eine Erhöhung der Integrationsdichte, die zu großen Chipflächen führen. Es hat sich gezeigt, daß Schaltungen gemäß der vorgenannten US-PS 4,829,350 oder ESD-Schutzschaltungen für dynamische Speicher vergleichsweise anfällig gegen ESD-Ereignisse sind. Bei dynamischen Speichern ist üblicherweise ein Dickoxid- bzw. Feldoxidtransistor vom Schaltkreisanschluß gegen das negative Versorgungsspannungspotential geschaltet. Weiterhin ist der Schaltkreisanschluß (Pad) über einen Widerstand und einen Dünnoxidtransistor mit dem negativen Versorgungsspannungspotential verbunden. Dabei arbeitet bei positiver elektostatischer Belastung der Dickoxidtransistor als ein im Lawinendurchbruch betriebener parasitärer Bipolartransistor, der die Überspannungen gegen das negative Versorgungsspannungspotential abführt. Eine direkte Stromverbindung des Schaltkreis-Anschlusses zum positiven Versorgungsspannungspotential ist nicht vorgesehen. Demgegenüber zeigen Schutzschaltungen, wie sie beispielsweise aus der EP 0 441 126 A2 oder der US-PS 4,066,918 bekannt sind, eine vergleichsweise geringe oder gar keine ESD-Empfindlichkeit.

Der Erfindung liegt die Aufgabe zugrunde, eine weitere Möglichkeit zum effektiven Schutz moderner Halbleiterchips gegen ESD-Ereignisse anzugeben.

Die Erfindung löst diese Aufgabe mit den Merkmalen des Patentanspruchs 1.

Der Erfindung liegt die Erkenntnis zugrunde, daß bei den zunehmenden Chipabmessungen moderner Speichergenerationen vor allem die langen Versorgungspotential-Leitungen einen Einfluß auf ESD-Ereignisse haben. Maßgebend ist der Leitungswiderstand aufgrund der endlichen Leiterbahnbreite. In Verbindung mit parasitären Kapazitäten kann dieser Widerstand bei ESD-Ereignissen mit hohen Stromspitzen lokale Überspannungen zur Folge haben, die zu chipinternen Ausfällen an den Source- bzw. Drainkontakten führen. Mit einem erfindungsgemäß vorgesehenen weiteren Ableitelement zwischen den Versorgungsspannungsleitungen läßt sich ein sicherer und kostengünstiger Schutz erreichen.

Ausgestaltungen der Erfindung sind in Unteransprüchen gekennzeichnet. Die Erfindung wird nachfolgend anhand eines in den Figuren der Zeichnung dargestellten Ausführungsbeispiels näher erläutert. Es zeigen:
- Figur 1: ein Prinzipschaltbild zur Erläuterung der Erfindung und
- Figur 2: einen Querschnitt durch einen erfindungsgemäßen Halbleiterchip an einem Schaltkreisanschluß.

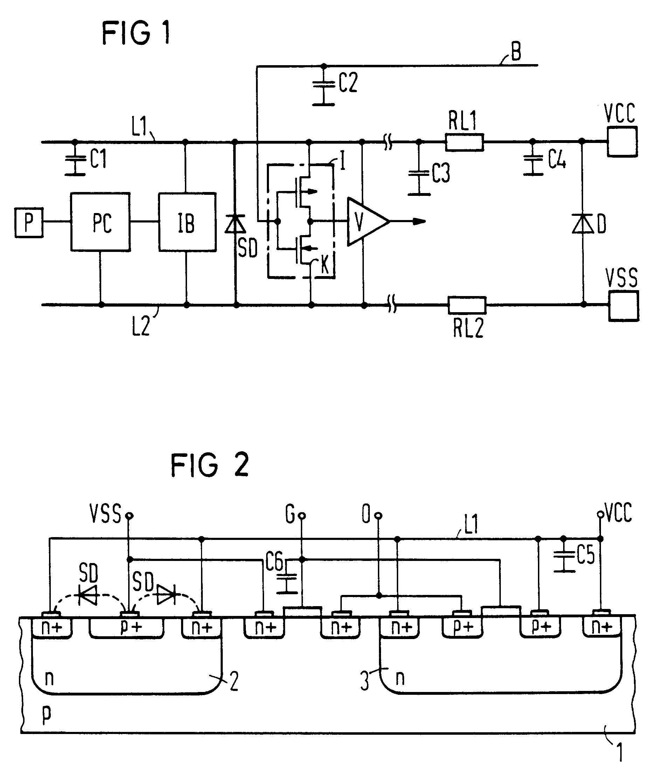

Gemäß Figur 1 wird ein Halbleiterchip von Anschlüssen VCC und VSS mit Spannung versorgt. Die an diesen Anschlüssen anliegenden Versorgungspotentiale befinden sich üblicherweise an der äußeren Peripherie der Schaltung und umrahmen den gesamten Chip. Die Anschlußpads P liegen an den Längs- und/oder Stirnseiten des Chips verteilt. Durch Anschlußdrähte (Bonddrähte) werden die Versorgungsleitungen und die Pads mit den Gehäuseanschlüssen verbunden. Die Schutzschaltung PC gegen elektrostatische Entladung liegt zwischen einem Anschlußpad P und beispielsweise der VSS-Leitung. Bei einem ESD-Ereignis führt die Schutzschaltung PC die Ladung niederohmig über die Versorgungsleitung gegen ein Bezugspotential, hier VSS ab. Der Schutzschaltung PC nachgeschaltet ist ein Eingangspuffer IB. Als Element der eigentlichen Schaltung ist ein Inverter I und ein Verstärker V dargestellt. Beide werden von den Versorgungspotential-Leitungen L1 und L2 versorgt. Der Eingang des Inverters ist mit einem internen Bus B verbunden. Der Inverter besitzt einen p-Kanal-Transistor und einen n-Kanal-Transistor. Der Sourceanschluß des n-Kanal-Transistors ist mit einem Knoten K verbunden, der an die Versorgungspotential-Leitung L2 für VSS angeschlossen ist. Die Kapazitäten C1 bis C4 sind parasitäre Kapazitäten. Mit den Widerständen RL1 bzw. RL2 sind die Leitungswiderstände der Versorgungspotential-Leitungen für VCC bzw. VSS symbolisiert.

Bei einem ESD-Ereignis mit positiver Spannung am Anschlußpad P fließt die ESD-Ladung über die Schutzschaltung PC nach VSS ab. Das Gate des n-Kanal-Transistors ist durch parasitäre Kapazitäten C2 an Nullpotential geklemmt, so daß der Transistor sperrt. Die ebenfalls über parasitäre Kapazitäten C3, C4 an Nullnotential geklemmte Leitung L1 stellt eine große Ladungssenke dar und kann floaten. Da keine leitende Verbindung zwischen der Leitung L1 und der Leitung L2 für das negative Versorgungspotential VSS besteht, bleibt im ESD-Fall L1 zunächst auf Nullpotential. Der Stromfluß entlang der VSS-Leitung L2 verursacht aufgrund des verteilten Leiterbahnwiderstandes RL2 einen Potentialabfall, der im Bereich des Anschlußpads am höchsten ist, weil dort der gesamte Leiterbahnwiderstand am größten ist. Überschreitet das VSS-Potential bei den n-Kanal-Transistoren die Durchbruchspannung der Sourcegebiete bzw. die Punch-Spannung, so fließt ein Strom in den Knoten K. Über die Source fließt dieser Strom zu benachbarten Wannenanschlüssen bzw. zum Drain des n-Kanal-Transistors und weiter über den p-Kanal-Transistor zur VCC-Leitung L1. Der Strom über die Sourcegebiete der n-Kanal-Transistoren kann dabei so groß werden, daß es zu erwähnten Ausfällen aufgrund durchlegierter Kontaktlöcher kommt.

Bei Schutzschaltungen, die wie in der US-PS 4,066,918 Dioden zwischen dem Anschlußpad und jeweils einer Versorgungspotential-Leitung aufweisen, tritt das geschilderte Problem der lokalen Überspannung nicht auf, da die jeweilige komplementäre Diode die nicht belastete Versorgungspotential-Leitung auflädt. Bei positiver ESD-Spannung sperrt die zur VSS-Leitung liegende Diode. Die zur VCC-Leitung führende Diode ist in Durchlaßrichtung geschaltet und lädt die parasitäre Kapazität der Leitung auf. Sobald die ESD-Spannung die Durchbruchspannung der zur VSS-Leitung gelegten Diode überschreitet, wird die Ladung über diese Diode gegen VSS abgeführt. Durch die jeweils komplementären Ableitelemente kann in diesem Fall ein ungehinderter Potentialausgleich stattfinden.

Im Fall der ESD-Schaltungen, von dem die Erfindung ausgeht, haben Versuche gezeigt, daß grundsätzlich eine Verbreiterung der Versorgungspotential-Leitungen L1 und L2 zu einem ausreichenden Schutz genügen. Bei Speicherchips der nächsten Generationen ist jedoch zu erwarten, daß die Verbreiterung der Versorgungsbahnleitungen immer größer wird, so daß die Versorgungspotential-Leitungen einen erheblichen Anteil an der Chipfläche haben werden.

Gemäß der vorliegenden Erfindung ist deshalb vorgesehen, an jedem Schaltkreis-Anschluß (Pad) P eine Schutzdiode SD vorzusehen. Die Schutzdiode ist in Sperrichtung von der VCC-Leitung L1 zur VSS-Leitung L2 geschaltet. Die Diode muß dabei für hohe Stromdichten ausgelegt sein. Bei einem ESD-Ereignis, bei dem die Schutzschaltung PC aktiv wird, wird an dem Schaltkreis-Anschluß P die Schutzdiode SD leitend, sobald ihre Durchlaßspannung überschritten wird. Dadurch kann ein sofortiger Potentialausgleich zwischen den Leitungen L2 und L1 stattfinden, so daß die parasitären Kapazitäten, die in Verbindung mit den Leiterbahnwiderständen große Zeitkonstanten ergeben, neutralisiert werden.

Eine geänderte Chiparchitektur sieht vor, daß die Versorgungspotential-Leitungen nicht mehr wie bisher an der Peripherie des Chips verlaufen und den Chip umrahmen, sondern in der Mitte des Chips angebracht sind. Dies führt dazu, daß die Pads in der Mitte des Chips liegen müssen. Um die Anschlußdrähte zu den Pads möglichst kurz zu halten, müssen die Gehäuseanschlüsse über das Silizium an die Pads herangeführt werden.

Figur 2 zeigt einen Querschnitt durch einen Halbleiterchip mit erfindungsgemäß integrierter Schutzdiode. In einem p-leitfähigen Substrat 1 sind n-leitfähige Wannen 2 bzw. 3 angeordnet. In den Wannen 2 und 3 sowie im Substrat 1 sind n⁺- bzw. p⁺-Zonen angeordnet, die zum Anschluß jeweiliger Leitungen dienen. Das Gate G des dargestellten Inverters und die Versorgungspotential-Leitung L1 liegt über parasitäre Kapazitäten C6 bzw. C5 gegen ein Bezugspotential. Das Gate ist weiterhin mit den Gateanschlüssen des n-Kanal- bzw. p-Kanal-Transistors verbunden. An ihren jeweiligen Drainanschlüssen der Transistoren ist der Ausgangsanschluß 0 angeschlossen. Erfindungsgemäß ist in der Wanne 2 eine p⁺-Zone vorgesehen, die mit dem Anschluß VSS verbunden ist. Dieser Anschluß ist weiterhin mit der Source des n-Kanal-Transistors verbunden. In der Wanne 2 sind weiterhin im Querschnitt zwei n⁺-Zonen dargestellt, die mit der Versorgungspotential-Leitung L1 verbunden sind. Auf diese Weise ist zwischen der p⁺Zone und den n⁻-Zonen der Wanne 2 eine Schutzdiode SD gemäß Figur 1 realisiert. Bei dieser Ausführung der Erfindung ergibt sich der Effekt, daß aufgrund der Schutzdiode SD bei einem ESD-Ereignis das VCC-Potential im Abstand einer Diodenspannung dem Potential des Versorgungspotential-Anschlusses VSS folgen kann. Ohne die Schutzdiode SD würde die Versorgungspotential-Leitung L1 aufgrund der verteilten parasitären Kapazitäten C5 eine riesige Ladungssenke bilden, die das Potential VCC aufgrund der Leiterbahnwiderstände erst verzögert dem Potential VSS folgen lassen würde.

Die erfindungsgemäß vorgesehene großflächig ausgeführte Schutzdiode SD, die an jedem Anschlußpad P angeordnet ist, ist vom gleichen technologischen Typ wie einer der p-Kanal-Transistoren und sorgt dafür, daß die Potentialdifferenz zwischen VSS und VCC nicht größer wird als eine Diodenspannung und ein sofortiger Potentialausgleich herbeigeführt wird.

## Patentansprüche

1. Schaltungsanordnung zum Schutz integrierter Schaltkreise, insbesondere CMOS-Schaltkreise, bei der zwischen einem Schaltkreis-Anschluß und einer Versorgungspotential-Leitung bzw. zwischen Versorgungspotential-Anschlüssen Ableitelemente geschaltet sind,
**dadurch gekennzeichnet,**
daß neben jedem der lokalen Schaltkreis-Anschlüsse (P) ein weiteres lokales Ableitelement (SD) angeordnet ist, das jeweils zwischen die mit den Versorgungspotential-Anschlüssen (VSS, VCC) verbundenen Versorgungspotential-Leitungen (L1, L2) geschaltet ist.

2. Anordnung nach Anspruch 1,
**dadurch gekennzeichnet,**
daß das weitere Ableitelement eine Diode (SD) ist.

3. Anordnung nach Anspruch 1 oder 2,
**dadurch gekennzeichnet,**
daß das weitere Ableitelement vom gleichen technologischen Typ wie ein p-Kanal-Transistor ausgebildet ist.
